(19) Europäisches Patentamt / European Patent Office / Office européen des brevets

(11) **EP 3 933 413 A1**

(12) **EUROPEAN PATENT APPLICATION**

(43) Date of publication:
**05.01.2022 Bulletin 2022/01**

(51) Int Cl.:
***G01R 23/20*** *(2006.01)*   ***G01R 23/163*** *(2006.01)*

(21) Application number: **20182774.8**

(22) Date of filing: **29.06.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Rohde & Schwarz GmbH & Co. KG 81671 München (DE)**

(72) Inventors:
• **Schmaehling, Martin 82237 Wörthsee (DE)**
• **Ramian, Florian 85757 Karlsfeld (DE)**

(74) Representative: **Rupp, Christian et al Mitscherlich PartmbB Patent- und Rechtsanwälte Sonnenstraße 33 80331 München (DE)**

Remarks:
Amended claims in accordance with Rule 137(2) EPC.

(54) **METHOD AND DEVICE FOR DETERMINING ADJACENT CHANNEL LEAKAGE RATIO ON THE BASIS OF A BANDWIDTH-LIMITED MEASUREMENT**

(57) A method for determining adjacent channel leakage ratio on the basis of a measurement limited to a certain bandwidth is provided. Said method comprises the steps of determining an ideal output signal with respect to a device under test on the basis of a reference signal provided to the device under test, determining a model of non-linearities on the basis of a comparison between the ideal output signal and a measured output signal with respect to the device under test, and determining the adjacent channel leakage ratio on the basis of an out-of-band signal behavior created by applying the model.

Fig. 6

EP 3 933 413 A1

Printed by Jouve, 75001 PARIS (FR)

**Description**

The invention relates to a method for determining adjacent channel leakage ratio on the basis of a measurement limited to a certain bandwidth and a device and computer program for determining adjacent channel leakage ratio on the basis of a measurement limited to a certain bandwidth.

Generally, in times of an increasing number of communication applications providing wireless connectivity capabilities, there is a growing need of a method for determining adjacent channel leakage ratio on the basis of a measurement limited to a certain bandwidth and a device for determining adjacent channel leakage ratio on the basis of a measurement limited to a certain bandwidth for performing measurements with respect to such applications in order to verify their correct functioning.

EP 1 688 751 A1 relates to a method, wherein time correlation of signal to distortion characteristics is achieved by acquiring time domain data for a frequency band representing a communication signal, the communication signal having multiple channels. The time domain data is simultaneously converted to frequency and demodulation domain data in sequential time blocks. The frequency and demodulation domain data are processed to obtain respectively frequency and demodulation domain measurements. The resulting measurements are displayed simultaneously as a function of time for all the time blocks and/or for a selected one of the time blocks. Furthermore, a certain display provides a display having a time axis and a frequency axis in the form of bars spanning the frequency band for each time block with each bar being divided into frequency sub-bands representing a main channel and adjacent side channels, the shading of each segment of the bar representing a measurement value for that segment. Disadvantageously, especially due to the above-mentioned sequential time blocks, a single capture would not be sufficient, which leads to time-consuming, and thus inefficient, measurements.

Accordingly, there is an object to provide a method for determining adjacent channel leakage ratio on the basis of a measurement limited to a certain bandwidth and a device for determining adjacent channel leakage ratio on the basis of a measurement limited to a certain bandwidth, whereby a particularly high efficiency and accuracy of the measurement are ensured.

This object is solved by the features of the first independent claim for a method for determining adjacent channel leakage ratio on the basis of a measurement limited to a certain bandwidth and the features of the second independent claim for a device for determining adjacent channel leakage ratio on the basis of a measurement limited to a certain bandwidth. The dependent claims contain further developments.

According to a first aspect of the invention, a method for determining information, especially adjacent channel leakage ratio, on the basis of a measurement limited to a certain bandwidth is provided. Said method comprises the steps of determining an ideal output signal with respect to a device under test on the basis of a reference signal provided to the device under test, determining a model of non-linearities on the basis of a comparison between the ideal output signal and a measured output signal with respect to the device under test, and determining the adjacent channel leakage ratio on the basis of an out-of-band signal behavior created by applying the model. Advantageously, a single capture is sufficient for determining the adjacent channel leakage ratio, which saves time and therefore leads to a particularly high efficiency, thereby also ensuring a notably high accuracy.

According to a first preferred implementation form of the first aspect of the invention, the certain bandwidth comprises or is the bandwidth of the respective fundamental. In addition to this or as an alternative, the certain bandwidth comprises or is less than three-times the respective carrier bandwidth. Advantageously, for instance, costs can be reduced due to a narrow analysis bandwidth especially leading to less expensive hardware.

According to a second preferred implementation form of the first aspect of the invention, with respect to the reference signal, the method comprises the step of determining the reference signal on the basis of a demodulation of the respective fundamental. Advantageously, for example, complexity can be reduced, which leads to an increased efficiency.

According to a further preferred implementation form of the first aspect of the invention, with respect to the measured output signal, the method comprises the step of measuring over time in order to eliminate the respective noise via averaging, preferably I/Q averaging. Advantageously, for instance, accuracy can be increased in an efficient manner.

Further advantageously, said I/Q averaging is especially configured to average real and imaginary components of the respective complex baseband signal separately.

According to a further preferred implementation form of the first aspect of the invention, with respect to the measured output signal, the method comprises the step of equalizing in order to eliminate the respective frequency response. Advantageously, for example, inaccuracies can further be reduced.

According to a further preferred implementation form of the first aspect of the invention, the model comprises or is a mathematical model. In addition to this or as an alternative, the non-linearities comprise or are distortions. Advantageously, for instance, not only efficiency but also accuracy can be increased.

According to a further preferred implementation form of the first aspect of the invention, the model comprises or is a polynomial model. Advantageously, for example, complexity can be reduced, which leads to an increased efficiency.

According to a further preferred implementation form of the first aspect of the invention, with respect to the polynomial model, the method comprises the step of determining the respective third order coefficient and/or the respective fifth order coefficient. Advantageously, for instance, using just a part of the coefficients can further increase efficiency.

According to a further preferred implementation form of the first aspect of the invention, with respect to the polynomial model, the method comprises the step of determining the respective second order coefficient and/or the respective fourth order coefficient. Advantageously, for example, measurement time can be shortened by using just a part of the coefficients.

According to a further preferred implementation form of the first aspect of the invention, the non-linearities comprise or are memory effects distortions. In this context, with respect to the memory effects distortions, the method comprises the step of determining the memory effects distortions especially on the basis of the Volterra model, a memory polynomial model, a generalized memory polynomial model, or any combination thereof.. Advantageously, for instance, both efficiency and accuracy can further be increased. Further advantageously, with respect to the Volterra model, the memory polynomial model, the generalized memory polynomial model, or any combination thereof, respectively, it is noted that any mathematical model comprising and/or considering memory effects can be used.

According to a further preferred implementation form of the first aspect of the invention, the non-linearities comprise or are time non-linearities. In this context, with respect to the time non-linearities, the method comprises the step of determining the time non-linearities on the basis of iterations configured to find a respective pre-distortion eliminating the time non-linearities. Advantageously, for example, inaccuracies can be reduced in a particularly efficient manner.

According to a second aspect of the invention, a device for determining information, especially adjacent channel leakage ratio, on the basis of a measurement limited to a certain bandwidth is provided. Said device is configured to determine an ideal output signal with respect to a device under test on the basis of a reference signal provided to the device under test. The device is further configured to determine a model of non-linearities on the basis of a comparison between the ideal output signal and a measured output signal with respect to the device under test. In addition to this, the device is configured to determine the adjacent channel leakage ratio on the basis of an out-of-band signal behavior created by applying the model. Advantageously, a single capture is sufficient for determining the adjacent channel leakage ratio, which saves time and therefore leads to a particularly high efficiency, thereby also ensuring a notably high accuracy.

According to a first preferred implementation form of the second aspect of the invention, the device comprises or is a signal analyzer comprising a signal analysis bandwidth. In addition to this or as an alternative, the certain bandwidth comprises or is the bandwidth of the respective fundamental. Further additionally or further alternatively, the certain bandwidth comprises or is less than three-times the respective carrier bandwidth. Advantageously, for instance, costs can be reduced due to a narrow analysis bandwidth especially leading to less expensive hardware.

According to a second preferred implementation form of the second aspect of the invention, with respect to the reference signal, the device is configured to determine the reference signal on the basis of a demodulation of the respective fundamental. In addition to this or as an alternative, in the case that the device comprises or is a signal analyzer, the signal analysis bandwidth comprises or is the certain bandwidth. Advantageously, for example, complexity can be reduced, which leads to an increased efficiency.

According to a further preferred implementation form of the second aspect of the invention, with respect to the measured output signal, the device is configured to measure over time in order to eliminate the respective noise via averaging, preferably I/Q averaging. Advantageously, for instance, accuracy can be increased in an efficient manner. Further advantageously, said I/Q averaging is especially configured to average real and imaginary components of the respective complex baseband signal separately.

Exemplary embodiments of the invention are now further explained with respect to the drawings by way of example only, and not for limitation. In the drawings:

Fig. 1    shows a flow chart of an embodiment of the first aspect of the invention;

Fig. 2    shows a flow chart of a further embodiment of the inventive method;

Fig. 3    shows an exemplary embodiment of an inventive device;

Fig. 4    shows an exemplary perfect or ideal signal without non-linearities;

Fig. 5    shows an exemplary imperfect or real signal with non-linearities;

Fig. 6    shows the signal according to Fig. 5 with marked transmitting channel and adjacent channels;

Fig. 7   shows the signal according to Fig. 5 with marked analysis bandwidth;

Fig. 8   shows an exemplary embodiment of a polynomial model; and

Fig. 9   shows a further exemplary embodiment of a polynomial model.

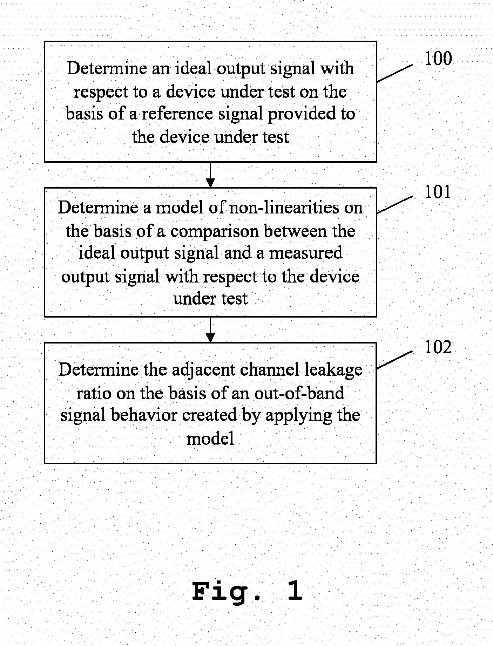

Fig. 1 shows a flow chart of an embodiment of the inventive method for determining adjacent channel leakage ratio on the basis of a measurement limited to a certain bandwidth. In a first step 100, an ideal output signal with respect to a device under test is determine on the basis of a reference signal provided to the device under test. Then, in a second step 101, a model of non-linearities is determined on the basis of a comparison between the ideal output signal and a measured output signal with respect to the device under test. Furthermore, in a third step 102, the adjacent channel leakage ratio is determined on the basis of an out-of-band signal behavior created by applying the model.

With respect to the reference signal, it is noted that the reference signal may especially comprise or be a known signal, preferably a known signal into the respective amplifier. With respect to the certain bandwidth, it is noted that the certain bandwidth may especially comprise or be the bandwidth of the respective fundamental. In addition to this or as an alternative, the certain bandwidth may comprise or be less than three-times the respective carrier bandwidth.

Again, with respect to the reference signal, it might be particularly advantageous if the method comprises the step of determining the reference signal on the basis of a demodulation of the respective fundamental. With respect to the measured output signal, it might be particularly advantageous if the method comprises the step of measuring over time in order to eliminate the respective noise via averaging, preferably I/Q averaging. In addition to this or as an alternative, also with respect to the measured output signal, the method may especially comprise the step of equalizing in order to eliminate the respective frequency response.

With respect to the model, it is noted that the model may especially comprise or be a mathematical model. Additionally or alternatively, with respect to the non-linearities, the non-linearities may especially comprise or be distortions. In further addition to this or as a further alternative, also with respect to the model, the model, preferably the mathematical model, may especially comprise or be a polynomial model. In this context, the polynomial model may especially model the respective coefficients.

Furthermore, with respect to the polynomial model, the method may especially comprise the step of determining the respective third order coefficient and/or the respective fifth order coefficient. Additionally or alternatively, also with respect to the polynomial model, the method may especially comprise the step of determining the respective second order coefficient and/or the respective fourth order coefficient.

Again, with respect to the non-linearities, the non-linearities may especially comprise or be memory effects distortions. In this context, with respect to the memory effects distortions, the method may especially comprise the step of determining the memory effects distortions on the basis of the Volterra model, a memory polynomial model, a generalized memory polynomial model, or any combination thereof.

In addition to this or as an alternative, the non-linearities may comprise or be time non-linearities. Furthermore, with respect to the time non-linearities, the method may especially comprise the step of determining the time non-linearities on the basis of iterations configured to find a respective pre-distortion eliminating the time non-linearities. For instance, said time non-linearities may especially comprise or be memory effects, preferably the memory effects distortions.

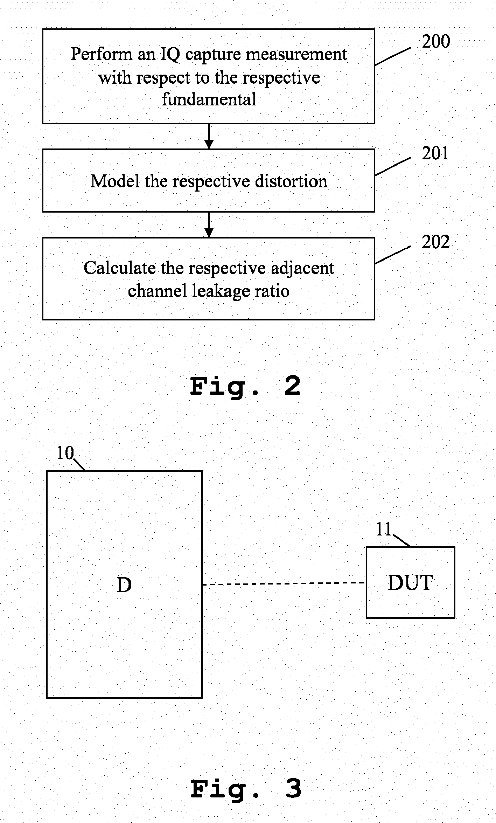

Fig. 2 illustrates a flow chart of a further embodiment of the inventive method for determining adjacent channel leakage ratio on the basis of a measurement limited to a certain bandwidth. In this context, it is noted that this second embodiment of the inventive method can at least partly be seen as an addition or as an alternative to the first embodiment according to Fig. 1. Accordingly, these two embodiments could also be combined especially in order to form further embodiments of the inventive method. It is further noted that these combinations or further embodiments (including the first and the second embodiment according to Fig. 1 and Fig. 2), respectively, do analogously apply for the inventive device such as the exemplary embodiment thereof according to Fig. 3.

As it can be seen from Fig. 2, in a first step 200, an IQ (In-phase Quadrature-phase) capture measurement is performed with respect to the respective fundamental. According to a second step 201, the respective distortion is modelled. Then, in a third step 202, the respective adjacent channel leakage ratio is calculated. With respect to the first step 200, it is noted that the respective fundamental may especially comprise at least one higher order distortion such as third and/or fifth order distortions.

In addition to this or as an alternative, with respect to the second step 201, it is noted that the respective distortion may especially be modelled by a polynomial algorithm such as the polynomial model according to the first embodiment of Fig. 1. In this context, as an alternative, another algorithm such as an iteration may be used.

Furthermore, with respect to the third step 202, it is noted that in addition or as an alternative to the respective adjacent channel leakage ratio, the respective error vector magnitude may be calculated. It is further noted that the calculation of the respective adjacent channel leakage ration and/or the respective error vector magnitude may preferably be based on the model, especially the model of the respective distortion, and/or on at least one, especially one, set of IQ data.

It is generally noted that the invention provides the benefit that only one, especially only one narrow band, capture is necessary, which saves not only time but also costs. Further advantageously, especially with respect to a device for determining the adjacent channel leakage ratio, there is no need to switch between a swept spectrum and an IQ mode. Furthermore, the invention especially allows for no stitching of several captures. As a further benefit, it is noted that especially in accordance with the invention, one capture is sufficient not only for adjacent channel leakage ratio but also for error magnitude vector measurements.

In Fig. 3, a block diagram of an exemplary embodiment of the inventive device 10 for determining adjacent channel leakage ratio on the basis of a measurement limited to a certain bandwidth is shown.

In this context, the device 10 is configured to determine an ideal output signal with respect to a device under test 11 on the basis of a reference signal provided to the device under test 11. The device 10 is further configured to determine a model of non-linearities on the basis of a comparison between the ideal output signal and a measured output signal with respect to the device under test 11. In addition to this the device 10 is configured to determine the adjacent channel leakage ratio on the basis of an out-of-band signal behavior created by applying the model.

It is noted that it might be particularly advantageous if the device 10 comprises or is a signal analyzer comprising a signal analysis bandwidth. In addition to this or as an alternative, the certain bandwidth may especially comprise or be the bandwidth of the respective fundamental. Further additionally or further alternatively, the certain bandwidth may especially comprise or be less than three-times the respective carrier bandwidth. In this context, especially with respect to the signal analyzer, the device 10 may alternatively comprise or be a spectrum analyzer.

Furthermore, with respect to the reference signal, the device 10 may especially be configured to determine the reference signal on the basis of a demodulation of the respective fundamental. In addition to this or as an alternative, especially in the case that the device 10 comprises or is a signal analyzer or a spectrum analyzer, the signal analysis bandwidth may comprise or be the certain bandwidth. Accordingly, the signal analysis bandwidth may preferably be less than three-times the respective carrier bandwidth.

Moreover, with respect to the measured output signal, the device 10 may especially be configured to measure over time in order to eliminate the respective noise via averaging, preferably I/Q averaging. In addition to this or as an alternative, also with respect to the measured output signal, the device 10 may especially be configured to equalize in order to eliminate the respective frequency response.

With respect to the model, it is noted that the model may especially comprise or be a mathematical model. Additionally or alternatively, with respect to the non-linearities, it is noted that the non-linearities may especially comprise or be distortions. In further addition to this or as a further alternative, the model, preferably the mathematical model, may especially comprise or be a polynomial model.

In this context, with respect to the polynomial model, the device 10 may especially be configured to determine the respective third order coefficient and/or the respective fifth order coefficient. In addition to this or as an alternative, also with respect to the polynomial model, the device 10 may especially be configured to determine the respective second order coefficient and/or the respective fourth order coefficient.

Again, with respect to the non-linearities, it is noted that the non-linearities may especially comprise or be memory effects distortions. In this context, with respect to the memory effects distortions, the device 10 may especially be configured to determine the memory effects distortions on the basis of the Volterra model, a memory polynomial model, a generalized memory polynomial model, or any combination thereof.

Additionally or alternatively, also with respect to the non-linearities, it is noted that the non-linearities may especially comprise or be time non-linearities. In this context, with respect to the time non-linearities, the device 10 may especially be configured to determine the time non-linearities such as memory effects, preferably the memory effects distortions, on the basis of iterations configured to find a respective pre-distortion eliminating the time non-linearities.

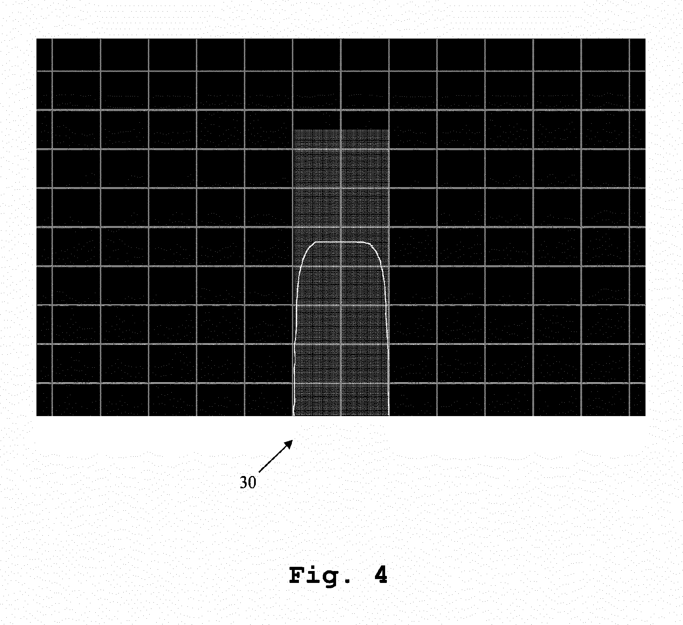

In Fig. 4, an exemplary signal 30 is shown. As it can be seen, said signal 30 is a perfect or ideal signal. Accordingly, there are no non-linearities and there is no adjacent channel leakage.

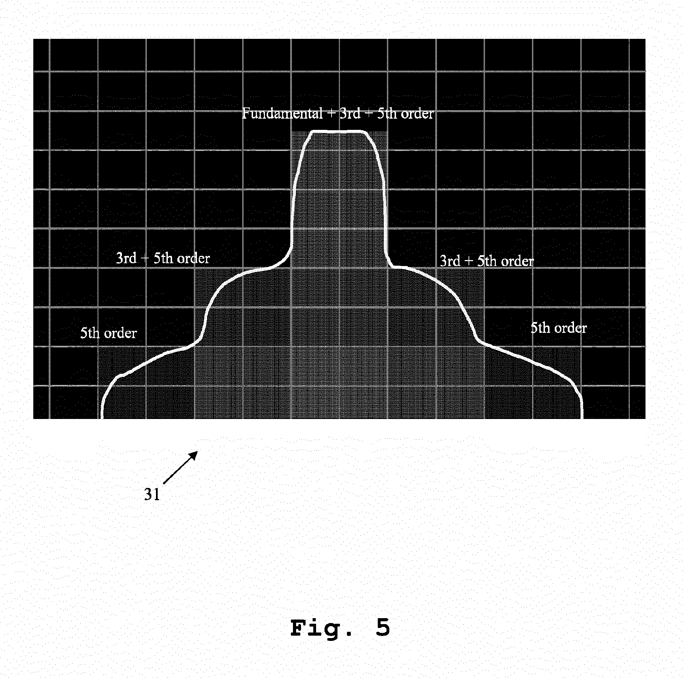

In contrast to Fig. 4, Fig. 5 illustrates an exemplary imperfect or real signal 31. In this context, non-linearities especially cause spectral regrowth. Accordingly, the respective fundamental signal is especially underlaid with higher order distortions. As it can be seen from Fig. 5, the fundamental signal is exemplarily underlaid with a third and a fifth order distortion. For instance, it is noted that an IQ capturing of the fundamental would especially capture also a part of the higher order distortions, exemplarily the third and the fifth order distortions.

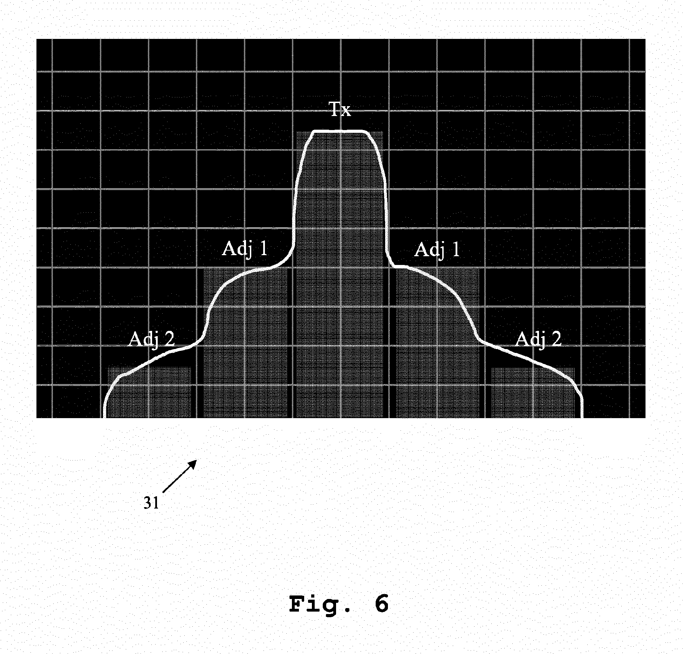

Fig. 6 shows the real signal 31 with non-linearities according to Fig. 5 again. In this context, the respective transmitting channel (Tx) and adjacent channels, exemplarily two adjacent channels (Adj 1 and Adj 2), are marked.

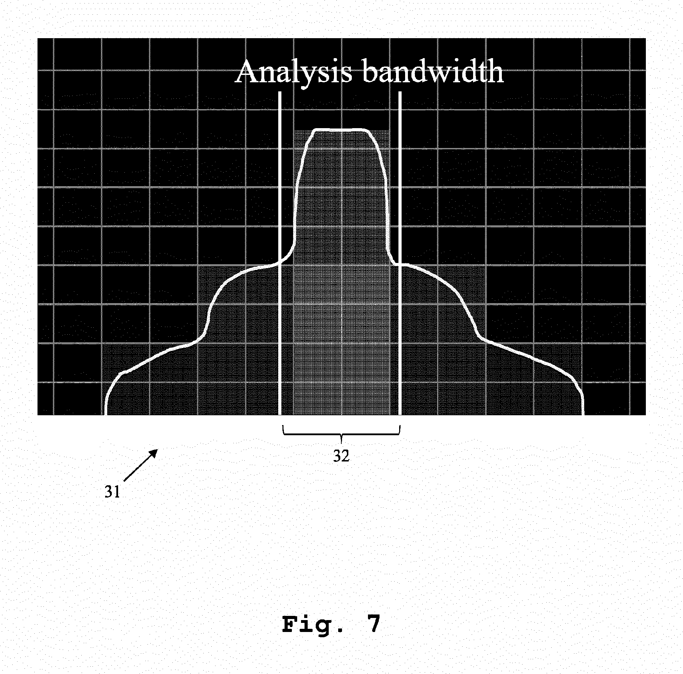

Moreover, Fig. 7 shows the imperfect or real signal 31 with non-linearities according to Fig. 5 or Fig. 6, respectively, again. As it can be seen from Fig. 7, the respective analysis bandwidth 32 is marked. Exemplarily, the analysis bandwidth 32 is especially equal to the bandwidth of the respective fundamental.

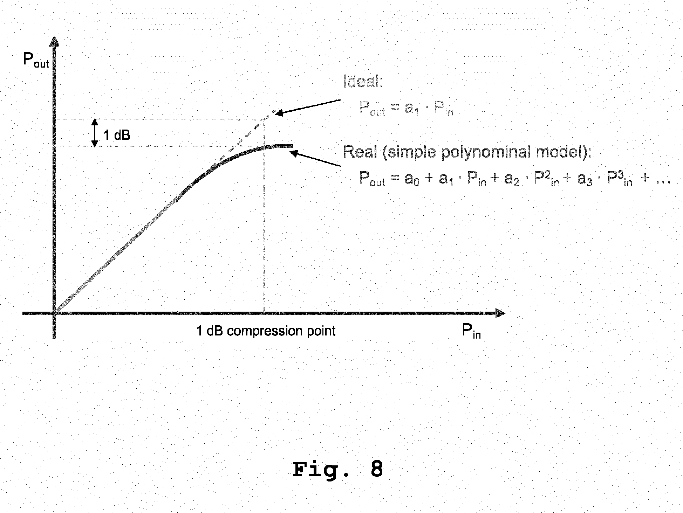

Now, with respect to Fig. 8, an exemplary embodiment of a polynomial model is illustrated. More specifically, Fig. 8 shows the output power as a function of the respective input power with respect to an ideal signal such as the signal 30 of Fig. 4 and with respect to a real signal such as the signal 31 according to Fig. 5.

In accordance with Fig. 8, for an ideal signal, the following equation applies:

$$P_{out} = a_1 \cdot P_{in} \quad , \qquad (1)$$

wherein $P_{out}$ denotes the output power,
wherein $a_1$ denotes a coefficient, and
wherein $P_{in}$ denotes the input power.

Furthermore, for a real signal, especially in accordance with a simple polynomial model, the following equation applies:

$$P_{out} = a_0 + a_1 \cdot P_{in} + a_2 \cdot P_{in}^2 + a_3 \cdot P_{in}^3 + \cdots \quad , \qquad (2)$$

wherein, as already noted above, $P_{out}$ denotes the output power,
wherein $a_0, a_1, a_2, a_3, \ldots$ denote coefficients, especially polynomial coefficients, and
wherein, as already noted above, $P_{in}$ denotes the input power.

As it can further be seen from Fig. 8, the respective 1 dB compression point with respect to the ideal and the real signal is marked.

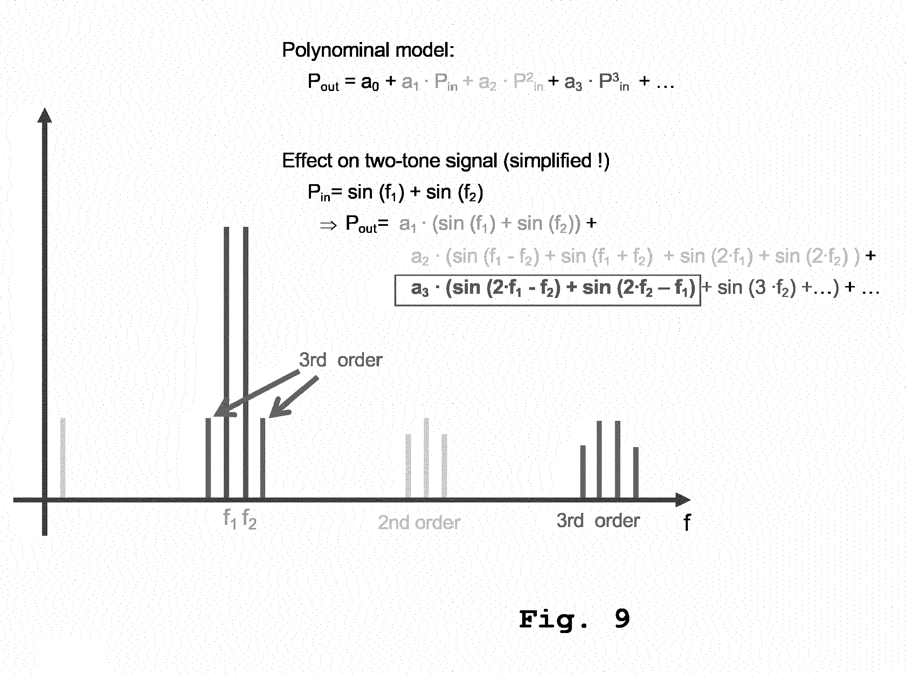

Finally, Fig. 9 illustrates a further exemplary embodiment of a polynomial model. In this context, the above-mentioned equation (2) is exemplarily applied to a two-tone signal comprising the frequencies $f_1$ and $f_2$. Additionally, second and third order distortions are exemplarily depicted.

Accordingly, for the respective input power of said two-tone signal, the following applies:

$$P_{in} = \sin(f_1) + \sin(f_2) \quad . \qquad (3)$$

Now, the corresponding output power can be calculated especially in a simplified manner with the aid of equation (2) as follows:

$$P_{out} = a_1(\sin(f_1) + \sin(f_2))$$
$$+a_2(\sin(f_1 - f_2) + \sin(f_1 + f_2) + \sin(2 \cdot f_1) + \sin(2 \cdot f_2))$$
$$+a_3(\sin(2 \cdot f_1 - f_2) + \sin(2 \cdot f_2 - f_1) + \sin(3 \cdot f_2) + \cdots) + \cdots \quad . \qquad (4)$$

It is noted that the knowledge of the polynomial coefficients allows to derive the respective spectral regrowth.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A method for determining adjacent channel information on the basis of a measurement limited to a certain bandwidth, the method comprising the steps of:

determining an ideal output signal with respect to a device under test (11) on the basis of a reference signal provided to the device under test (11),

determining a model of non-linearities on the basis of a comparison between the ideal output signal and a measured output signal with respect to the device under test (11), and

determining the adjacent channel information on the basis of an out-of-band signal behavior created by applying the model.

2. The method according to claim 1,
wherein the certain bandwidth comprises or is the bandwidth of the respective fundamental, and/or
wherein the certain bandwidth comprises or is less than three-times the respective carrier bandwidth.

3. The method according to claim 1 or 2,
wherein with respect to the reference signal, the method comprises the step of determining the reference signal on the basis of a demodulation of the respective fundamental.

4. The method according to any of the claims 1 to 3,
wherein with respect to the measured output signal, the method comprises the step of measuring over time in order to eliminate the respective noise via averaging, preferably I/Q averaging.

5. The method according to any of the claims 1 to 4,
wherein with respect to the measured output signal, the method comprises the step of equalizing in order to eliminate the respective frequency response.

6. The method according to any of the claims 1 to 5,
wherein the model comprises or is a mathematical model, and/or
wherein the non-linearities comprise or are distortions.

7. The method according to any of the claims 1 to 6,
wherein the model comprises or is a polynomial model and/or
wherein the adjacent channel information determined is an adjacent channel leakage ratio.

8. The method according to claim 7,
wherein with respect to the polynomial model, the method comprises the step of determining the respective third order coefficient and/or the respective fifth order coefficient.

9. The method according to claim 7 or 8,
wherein with respect to the polynomial model, the method comprises the step of determining the respective second order coefficient and/or the respective fourth order coefficient.

10. The method according to any of the claims 1 to 9,
wherein the non-linearities comprise or are memory effects distortions,
wherein with respect to the memory effects distortions, the method comprises the step of determining the memory effects distortions especially on the basis of the Volterra model, a memory polynomial model, a generalized memory polynomial model, or any combination thereof.

11. The method according to any of the claims 1 to 10,
wherein the non-linearities comprise or are time non-linearities,
wherein with respect to the time non-linearities, the method comprises the step of determining the time non-linearities on the basis of iterations configured to find a respective pre-distortion eliminating the time non-linearities.

12. A device (10) for determining adjacent channel information on the basis of a measurement limited to a certain bandwidth, the device (10) being configured to
determine an ideal output signal with respect to a device under test (11) on the basis of a reference signal provided to the device under test (11),
determine a model of non-linearities on the basis of a comparison between the ideal output signal and a measured output signal with respect to the device under test (11), and
determine the adjacent channel information on the basis of an out-of-band signal behavior created by applying the model.

**13.** The device (10) according to claim 12,
wherein the device (10) comprises or is a signal analyzer comprising a signal analysis bandwidth (32), and/or
wherein the certain bandwidth comprises or is the bandwidth of the respective fundamental, and/or
wherein the certain bandwidth comprises or is less than three-times the respective carrier bandwidth.

**14.** The device (10) according to claim 12 or 13,
wherein with respect to the reference signal, the device (10) is configured to determine the reference signal on the basis of a demodulation of the respective fundamental.

**15.** The device (10) according to claim 13,
wherein, the signal analysis bandwidth (32) comprises or is the certain bandwidth.

**16.** The device (10) according to any of the claims 12 to 15,
wherein with respect to the measured output signal, the device (10) is configured to measure over time in order to eliminate the respective noise via averaging, preferably I/Q averaging, and/or
wherein the adjacent channel information determined is an adjacent channel leakage ratio.

**17.** A computer program with computer program means for performing all steps of any of claims 1 to 11 if the computer program runs on a computer or digital signal processor.

Amended claims in accordance with Rule 137(2) EPC.

**1.** A method for determining adjacent channel information on the basis of a measurement limited to a certain bandwidth, the method comprising the steps of:

determining an ideal output signal with respect to a device under test (11) on the basis of a reference signal provided to the device under test (11),
determining a model of non-linearities on the basis of a comparison between the ideal output signal and a measured output signal with respect to the device under test (11),
determining the adjacent channel information on the basis of an out-of-band signal behavior created by applying the model, and
with respect to the measured output signal, measuring over time in order to eliminate the respective noise via I/Q averaging or equalizing in order to eliminate the respective frequency response.

**2.** The method according to claim 1,

wherein the certain bandwidth comprises or is the bandwidth of the respective fundamental, and/or
wherein the certain bandwidth comprises or is less than three-times the respective carrier bandwidth.

**3.** The method according to claim 1 or 2,
wherein with respect to the reference signal, the method comprises the step of determining the reference signal on the basis of a demodulation of the respective fundamental.

**4.** The method according to any of the claims 1 to 3, wherein the model comprises or is a mathematical model, and/or wherein the non-linearities comprise or are distortions.

**5.** The method according to any of the claims 1 to 4, wherein the model comprises or is a polynomial model and/or wherein the adjacent channel information determined is an adjacent channel leakage ratio.

**6.** The method according to claim 5,
wherein with respect to the polynomial model, the method comprises the step of determining the respective third order coefficient and/or the respective fifth order coefficient.

**7.** The method according to claim 5 or 6,
wherein with respect to the polynomial model, the method comprises the step of determining the respective second order coefficient and/or the respective fourth order coefficient.

**8.** The method according to any of the claims 1 to 7,

wherein the non-linearities comprise or are memory effects distortions,
wherein with respect to the memory effects distortions, the method comprises the step of determining the memory effects distortions especially on the basis of the Volterra model, a memory polynomial model, a generalized memory polynomial model, or any combination thereof.

9. The method according to any of the claims 1 to 8, wherein the non-linearities comprise or are time non-linearities, wherein with respect to the time non-linearities, the method comprises the step of determining the time non-linearities on the basis of iterations configured to find a respective pre-distortion eliminating the time non-linearities.

10. A device (10) for determining adjacent channel information on the basis of a measurement limited to a certain bandwidth, the device (10) being configured to

determine an ideal output signal with respect to a device under test (11) on the basis of a reference signal provided to the device under test (11),
determine a model of non-linearities on the basis of a comparison between the ideal output signal and a measured output signal with respect to the device under test (11),
determine the adjacent channel information on the basis of an out-of-band signal behavior created by applying the model, and
with respect to the measured output signal, measure over time in order to eliminate the respective noise via I/Q averaging or equalize in order to eliminate the respective frequency response.

11. The device (10) according to claim 10,

wherein the device (10) comprises or is a signal analyzer comprising a signal analysis bandwidth (32), and/or
wherein the certain bandwidth comprises or is the bandwidth of the respective fundamental, and/or
wherein the certain bandwidth comprises or is less than three-times the respective carrier bandwidth.

12. The device (10) according to claim 10 or 11,
wherein with respect to the reference signal, the device (10) is configured to determine the reference signal on the basis of a demodulation of the respective fundamental.

13. The device (10) according to claim 11,
wherein, the signal analysis bandwidth (32) comprises or is the certain bandwidth.

14. The device (10) according to any of the claims 10 to 13,
wherein the adjacent channel information determined is an adjacent channel leakage ratio.

15. A computer program with computer program means for performing all steps of any of claims 1 to 9 if the computer program runs on a computer or digital signal processor.

Determine an ideal output signal with respect to a device under test on the basis of a reference signal provided to the device under test — 100

Determine a model of non-linearities on the basis of a comparison between the ideal output signal and a measured output signal with respect to the device under test — 101

Determine the adjacent channel leakage ratio on the basis of an out-of-band signal behavior created by applying the model — 102

# Fig. 1

Perform an IQ capture measurement
with respect to the respective
fundamental

200

Model the respective distortion

201

Calculate the respective adjacent
channel leakage ratio

202

# Fig. 2

10

D

11

DUT

# Fig. 3

Fig. 4

Fig. 5

Fig. 6

Fig. 7

$P_{out}$

Ideal:

$P_{out} = a_1 \cdot P_{in}$

1 dB

Real (simple polynominal model):

$P_{out} = a_0 + a_1 \cdot P_{in} + a_2 \cdot P^2_{in} + a_3 \cdot P^3_{in} + \ldots$

1 dB compression point

$P_{in}$

**Fig. 8**

Polynominal model:

$$P_{out} = a_0 + a_1 \cdot P_{in} + a_2 \cdot P^2_{in} + a_3 \cdot P^3_{in} + \ldots$$

Effect on two-tone signal (simplified !)

$$P_{in} = \sin(f_1) + \sin(f_2)$$

$$\Rightarrow P_{out} = a_1 \cdot (\sin(f_1) + \sin(f_2)) +$$

$$a_2 \cdot (\sin(f_1 - f_2) + \sin(f_1 + f_2) + \sin(2 \cdot f_1) + \sin(2 \cdot f_2)) +$$

$$\boxed{a_3 \cdot (\sin(2 \cdot f_1 - f_2) + \sin(2 \cdot f_2 - f_1)} + \sin(3 \cdot f_2) + \ldots) + \ldots$$

3rd order

$f_1\ f_2$    2nd order    3rd order    f

EP 3 933 413 A1

Fig. 9

Europäisches
Patentamt

European
Patent Office

Office européen
des brevets

# EUROPEAN SEARCH REPORT

Application Number

EP 20 18 2774

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAMMI OUALID ET AL: "Agile broadband behavioral modelling of nonlinear power amplifiers using coarse-predistortion technique", 2018 INTERNATIONAL CONFERENCE ON SIGNALS AND SYSTEMS (ICSIGSYS), IEEE, 1 May 2018 (2018-05-01), pages 7-12, XP033354371, DOI: 10.1109/ICSIGSYS.2018.8373571 [retrieved on 2018-06-05] * II. Coarse-Predistortion Based Linearization; III. Experimental Validation * | 1-17 | INV. G01R23/20 ADD. G01R23/163 |
| X | US 2020/021253 A1 (GHANNOUCHI FADHEL [CA] ET AL) 16 January 2020 (2020-01-16) * paragraph [0033] - paragraph [0054] * * figures 4,8,9,10A * | 1-17 | |
| X | US 10 379 162 B1 (OKUYAMA SHO [JP] ET AL) 13 August 2019 (2019-08-13) * claims 1,2 * * column 5, line 1 - line 10 * | 1-17 | TECHNICAL FIELDS SEARCHED (IPC) G01R H03F |
| X | GARD K G ET AL: "The Impact of RF Front-End Characteristics on the Spectral Regrowth of Communications Signals", IEEE TRANSACTIONS ON MICROWAVE THEORY AND TECHNIQUES, PLENUM, USA, vol. 53, no. 6, 1 June 2005 (2005-06-01), pages 2179-2186, XP011134729, ISSN: 0018-9480, DOI: 10.1109/TMTT.2005.848801 * the whole document * | 1-17 | |
| A | JP H11 154880 A (FUJITSU LTD) 8 June 1999 (1999-06-08) * the whole document * | 1-17 | |

-/--

The present search report has been drawn up for all claims

| Place of search | Date of completion of the search | Examiner |
|---|---|---|
| Munich | 18 December 2020 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 20 18 2774

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 101 195 977 B1 (UNIV SOGANG IND UNIV COOP FOUN [KR]) 30 October 2012 (2012-10-30) * the whole document * | 1-17 | |
| A | US 2009/058521 A1 (FERNANDEZ ANDREW D [US]) 5 March 2009 (2009-03-05) * the whole document * | 10 | |
| A | US 2004/098215 A1 (GEE KEVIN [US] ET AL) 20 May 2004 (2004-05-20) * the whole document * | 1-17 | |

TECHNICAL FIELDS
SEARCHED        (IPC)

The present search report has been drawn up for all claims

| Place of search | Date of completion of the search | Examiner |
|---|---|---|
| Munich | 18 December 2020 | Meliani, Chafik |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

page 2 of 2

## ANNEX TO THE EUROPEAN SEARCH REPORT
## ON EUROPEAN PATENT APPLICATION NO.

EP 20 18 2774

This annex lists the patent family members relating to the patent documents cited in  the above-mentioned European search report.
The members are as contained in the European Patent Office EDP file on
The European Patent Office is in no way liable for these particulars which are merely given for the purpose of information.

18-12-2020

| Patent document cited in search report | | Publication date | Patent family member(s) | | Publication date |
|---|---|---|---|---|---|
| US 2020021253 | A1 | 16-01-2020 | CA 3059091 A1 | | 23-08-2018 |
| | | | US 2020021253 A1 | | 16-01-2020 |
| | | | WO 2018148822 A1 | | 23-08-2018 |
| US 10379162 | B1 | 13-08-2019 | NONE | | |
| JP H11154880 | A | 08-06-1999 | NONE | | |
| KR 101195977 | B1 | 30-10-2012 | NONE | | |
| US 2009058521 | A1 | 05-03-2009 | NONE | | |
| US 2004098215 | A1 | 20-05-2004 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1688751 A1